# EUROPEAN PATENT SPECIFICATION

(11) **EP 3 869 565 B1**
(45) Date of publication and mention of the grant of the patent: **24.04.2024**
(21) Application number: 20208212.9
(22) Date of filing: 17.11.2020
(51) Int. Cl.: H10K 50/842, H10K 59/131

(54) **DISPLAY DEVICE**
ANZEIGEVORRICHTUNG
DISPOSITIF D'AFFICHAGE

(30) Priority: 19.02.2020 KR 20200020548
(43) Date of publication of application: 25.08.2021
(73) Proprietor: Samsung Display Co., Ltd., Yongin-si Gyeonggi-do 17113 (KR)
(72) Inventor: BANG, Kiho, 17113 Gyeonggi-Do (KR); CHOI, Wonsuk, 17113 Gyeonggi-Do (KR)
(74) Representative: Taor, Simon Edward William

(56) References cited:
- WO-A1-2019/187137
- US-A1- 2019 165 312
- US-A1- 2020 006 461
- US-B2- 10 553 669

## Description

### BACKGROUND

### 1. FIELD

The invention relates to a display device and is set out in the appended set of claims.

### 2. DESCRIPTION OF RELATED ART

Display devices are apparatuses for visually displaying data. Recently, the usage of display devices has diversified. In addition, as display devices have become thinner and lighter, their range of use has gradually been extended.

The display devices include a substrate divided into a display area and a non-display area outside the display area. The non-display area includes a dead space on which an image is not displayed. Non-display elements such as a pad portion, wirings, and a driving circuit portion are arranged in the non-display area. Recently, the demand for further reducing the dead space of the display devices has been increasing. However, as a dead space is reduced, the width of a voltage line arranged in the dead space should also be reduced. Consequently, an increase of power consumption caused by an increase of a resistance of the voltage line, and deterioration of display quality of the display devices caused by a voltage drop may be caused.

[A] US 2020/006461 A1 relates to a display apparatus having an insulating dam formed in a non-display area.

WO 2019/187137 A1 relates to a display device.

### SUMMARY

[B] According to an aspect of the present invention, there is provided a display device according to claim 1.

One or more embodiments include a display device which may prevent a voltage drop of a voltage line caused by reduction of a dead space.

Additional aspects will be set forth in part in the description which follows and, in part, will be apparent from the description, or may be learned by practice of the presented embodiments of the disclosure.

According to the invention as defined in claim 1, a display device includes a substrate including a display area, a non-display area, and a pad area. The non-display area is outside the display area, and the pad area is on one side of the non-display area. A first restriction dam is in the non-display area and surrounds the display area. A second restriction dam is in the non-display area and surrounds the display area between the display area and the first restriction dam. A bank surrounds the display area outside the first restriction dam. A voltage line is configured to supply a voltage to a display element inside the display area. The first restriction dam and the second restriction dam are on the voltage line between the display area and the pad area. The voltage line extends to the bank beyond the first restriction dam.

The voltage line includes a first voltage line and a second voltage line. The first voltage line is between the display area and the pad area. The second voltage line surrounds two opposites ends of the first voltage line and at least a portion of the display area. An outer end of the second voltage line facing the pad area is covered by the bank between the display area and the pad area.

A difference between a width of the bank and a width of the second voltage line may be 1.5 µm or more between the display area and the pad area, the width of the bank being taken in a direction perpendicular to a lengthwise direction of the bank, and the width of the second voltage line being covered by the bank.

A distance between the outer end of the second voltage line and an outer surface of the bank may be 1.5 µm or more.

An outer end of the first voltage line that faces the pad area is covered by the bank between two opposite ends of the second voltage line.

The outer end of the first voltage line and the outer end of the second voltage line may be on the same straight line.

The second voltage line may extend to the outside of the bank from a region surrounding the display area.

The display device may further include a crack prevention portion extending along an edge of the substrate, and a cover layer covering the crack prevention layer. The crack prevention layer is formed by removing a portion of inorganic layers stacked on the substrate, wherein an end of the second voltage line extending to the outside of the bank may be covered by the cover layer.

A height of the second restriction dam may be less than a height of the first restriction dam. The first restriction dam and the second restriction dam may be on the second voltage line between the display area and the pad area.

The display device may further include an encapsulation layer on the display element and including a first inorganic encapsulation layer, an organic encapsulation layer, and a second inorganic encapsulation layer that are sequentially stacked. The first inorganic encapsulation layer may directly contact the voltage line between the display area and the pad area.

### BRIEF DESCRIPTION OF THE DRAWINGS

The above and other aspects and features of certain embodiments of the disclosure will be more apparent from the following description taken in conjunction with the accompanying drawings.
FIG. 1 is a plan view of a display device according to an embodiment.
FIG. 2 is a cross-sectional view of an example of cross-sections of the display device taken along line I-I' and II-II' of FIG. 1.
FIG. 3 is a plan view of a region A of FIG. 1.
FIG. 4 is a plan view of a region B of FIG. 3.
FIG. 5 is a cross-sectional view of an example of a cross-section of the region B taken along line III-III' of FIG. 4.
FIG. 6 is a cross-sectional view of a bank portion of FIG. 5.
FIG. 7 is a plan view of the region A of FIG. 1.
FIG. 8 is a plan view of a region C of FIG. 7.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c.

Hereinafter, embodiments of the present disclosure are described in detail with reference to the accompanying drawings. When description is made with reference to the drawings, like reference numerals are used for like or corresponding elements and repeated descriptions of the like or corresponding elements are omitted.

It will be understood that although the terms "first," "second," etc. may be used herein to describe various components, these components should not be limited by these terms. These components are only used to distinguish one component from another.

As used herein, the singular forms "a," "an," and "the" are intended to include the plural forms as well, unless the context clearly indicates otherwise.

It will be further understood that the terms "comprises" and/or "comprising" used herein specify the presence of stated features or components, but do not preclude the presence or addition of one or more other features or components.

It will be understood that when a layer, region, or component is referred to as being "formed on," another layer, region, or component, it can be directly or indirectly formed on the other layer, region, or component. That is, for example, intervening layers, regions, or components may be present.

Sizes of elements in the drawings may be exaggerated or reduced for convenience of explanation. In other words, the sizes and thicknesses of components in the drawings are arbitrarily illustrated for convenience of explanation.

When a certain embodiment may be implemented differently, a specific process order may be performed differently from the described order. For example, two consecutively described processes may be performed substantially at the same time or performed in an order opposite to the described order.

It will be understood that when a layer, region, or component is referred to as being "connected" to another layer, region, or component, it may be "directly connected" to the another layer, region, or component and/or may be "indirectly connected" to the another layer, region, or component with other layer, region, or component interposed between the layer, region, or component and the another layer, region, or component. For example, it will be understood that when a layer, region, or component is referred to as being "electrically connected" to another layer, region, or component, it may be "directly electrically connected" to the another layer, region, or component and/or may be "indirectly electrically connected" to the another layer, region, or component with an other layer, region, or component interposed between the layer, region, or component and the another layer, region, or component.

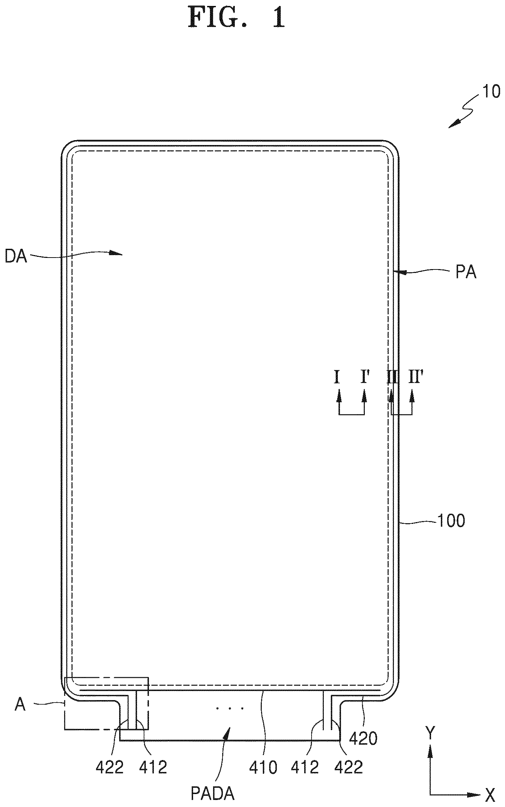

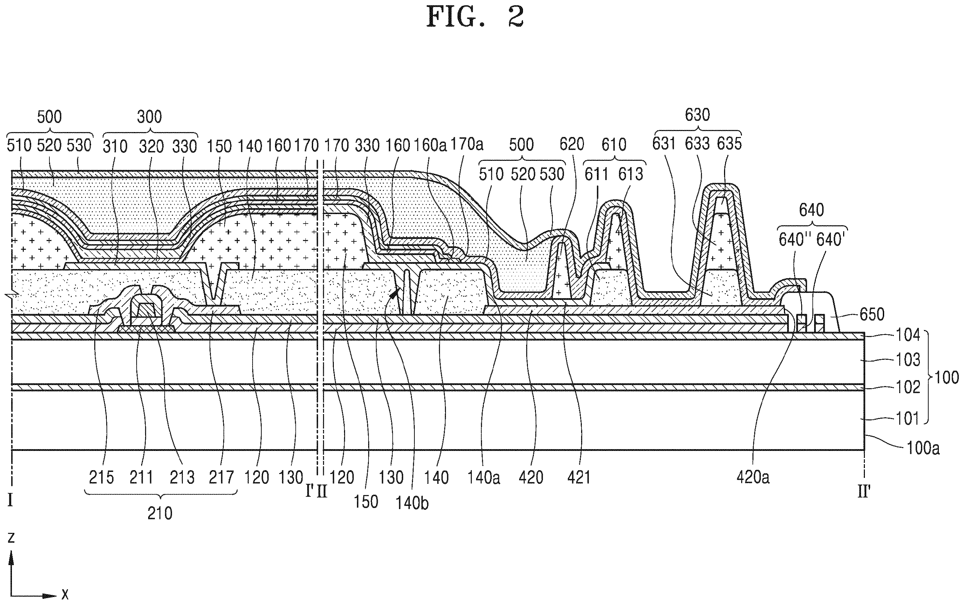

FIG. 1 is a plan view of a display device 10 according to an embodiment, and FIG. 2 is a cross-sectional view of an example of cross-sections of the display device 10 taken along line I-I' and II-II' of FIG. 1.

Referring to FIGS. 1 and 2, the display device 10 according to an embodiment includes a display area DA and a non-display area PA. The display area DA displays an image, and the non-display area PA is located outside the display area DA. A pad area PADA may be located inside the non-display area PA. A substrate 100 includes the display area DA, the non-display area PA, and the pad area PADA.

A display element is located in the display area DA. In addition to the display element, a thin film transistor 210 may be located in the display area DA, the thin film transistor 210 being electrically connected to the display element. It is shown in FIG. 2 that an organic light-emitting diode 300 as a display element is located in the display area DA. Electric connection of the organic light-emitting diode 300 to the thin film transistor 210 means that a pixel electrode 310 of the organic light-emitting diode 300 is electrically connected to the thin film transistor 210.

The non-display area PA includes the pad area PADA on one side of the non-display area PA, the pad area PADA being a region in which various electronic elements or a printed circuit board are electrically attached. A first voltage line 410 and a second voltage line 420 each applying a voltage to the display element may be located in the non-display area PA. For example, the first voltage line 410 may include a driving voltage line ELVDD, and the second voltage line 420 may include a common voltage line ELVSS.

The first voltage line 410 is arranged between the display area DA and the pad area PADA, e.g., see FIG. 1, to correspond to one side of the display area DA and be connected to a first connector 412 extending to the pad area PADA. The second voltage line 420 may surround the rest of regions of the display area DA and be connected to a second connector 422 extending to the pad area PADA.

FIG. 1 is a plan view of the substrate 100 under a process of manufacturing the display device 10. In final display device 10 or electronic apparatuses such as smartphone including the display device 10, a portion of the substrate 100 may be bent to minimize the area of the non-display area PA that is viewed by a user. In this case, the substrate 100 is bent such that the pad area PADA is located behind the display area DA. Accordingly, a user views that the display area DA occupies most of the display device 10.

The substrate 100 may include various flexible or bendable materials. For example, the substrate 100 may include a polymer resin such as polyethersulfone (PES), polyacrylate, polyetherimide (PEI), polyethylene naphthalate (PEN), polyethylene terephthalate (PET), polyphenylene sulfide (PPS), polyarylate (PAR), polyimide (PI), polycarbonate (PC), or cellulose acetate propionate (CAP). The substrate 100 may have a multi-layered structure including two layers including the above polymer resins, and a barrier layer between the two layers. The barrier layer includes an inorganic material such as silicon oxide, silicon nitride, silicon oxynitride.

Hereinafter, the configuration of the display device 10 is described in detail with reference to FIG. 2.

For example, the substrate 100 may have a multi-layered structure in which a first base layer 101, a first barrier layer 102, a second base layer 103, and a second barrier layer 104 are sequentially stacked.

The first base layer 101 and the second base layer 103 may include, for example, transparent glass including silicon oxide (SiO₂) as a main component. However, the first base layer 101 and the second base layer 103 may include a transparent plastic material. The transparent plastic material may include polyethersulfone (PES), polyacrylate, polyetherimide (PEI), polyethylene naphthalate (PEN), polyethylene terephthalate (PET), polyphenylene sulfide (PPS), polyarylate, polyimide, polycarbonate (PC), cellulose tri acetate (TAC), and cellulose acetate propionate (CAP).

The first base layer 101 and the second base layer 103 may have the same thickness or different thicknesses. For example, the first base layer 101 and the second base layer 103 may include polyimide and have a thickness ranging from about 3 µm to about 20 µm.

The first barrier layer 102 and the second barrier layer 104 serve as layers configured to prevent external foreign substances from penetrating into the display device 10 through the substrate 100 and include a single layer or a multi-layer including an inorganic material such as silicon nitride (SiNₓ) and/or silicon oxide (SiOₓ). For example, the first barrier layer 102 may include a multi-layer including an amorphous silicon layer and a silicon oxide layer for improving adhesive force between neighboring layers. The second barrier layer 104 may include a silicon oxide layer. In addition, the first barrier layer 102 and the second barrier layer 104 may respectively have a thickness ranging from about 4000 Å to about 7000 Å.

A buffer layer may be further formed on the substrate 100. The buffer layer may provide a flat surface to a top surface of the substrate 100 and block foreign substances or moisture penetrating through the substrate 100. For example, the buffer layer may include an inorganic material or an organic material. The inorganic material includes silicon oxide, silicon nitride, silicon oxynitride, aluminum oxide, aluminum nitride, titanium oxide, and titanium nitride, and the organic material includes polyimide, polyester, and acryl. The buffer layer may include a stacked body of the above materials. In an embodiment, the second barrier layer 104 of the substrate 100 may include a portion of the buffer layer having the multi-layered structure.

The thin film transistor 210 is arranged in the display area DA of the substrate 100. A thin film transistor may be arranged also in the non-display area PA of the substrate 100. The thin film transistor located in the non-display area PA may include, for example, a portion of a circuit portion configured to control an electric signal applied to the display area DA.

The thin film transistor 210 includes a semiconductor layer 211, a gate electrode 213, a source electrode 215, and a drain electrode 217. The semiconductor layer 211 includes amorphous silicon, polycrystalline silicon, or an organic semiconductor material. In the case where the buffer layer is located on the substrate 100, the semiconductor layer 211 may be located on the buffer layer.

The gate electrode 213 is arranged over the semiconductor layer 211. The source electrode 215 is electrically connected to the drain electrode 217 depending on a signal applied to the gate electrode 213. The gate electrode 213 may include at least one of, for example, aluminum (Al), platinum (Pt), palladium (Pd), silver (Ag), magnesium (Mg), gold (Au), nickel (Ni), neodymium (Nd), iridium (Ir), chrome (Cr), lithium (Li), calcium (Ca), molybdenum (Mo), titanium (Ti), tungsten (W), and copper (Cu). In this case, to secure insulation between the semiconductor layer 211 and the gate electrode 213, a first inorganic insulating layer 120 including an inorganic material may be arranged between the semiconductor layer 211 and the gate electrode 213, the inorganic material including silicon oxide, silicon nitride, and silicon oxynitride.

A second inorganic insulating layer 130 may be arranged on the gate electrode 213 and may have a single-layered structure or a multi-layered structure including an inorganic material including silicon oxide, silicon nitride, and silicon oxynitride.

The source electrode 215 and the drain electrode 217 are arranged on the second inorganic insulating layer 130. The source electrode 215 and the drain electrode 217 are electrically connected to the semiconductor layer 211 through contact holes formed in the second inorganic insulating layer 130 and the first inorganic insulating layer 120. The source electrode 215 and the drain electrode 217 may include at least one of aluminum (Al), platinum (Pt), palladium (Pd), silver (Ag), magnesium (Mg), gold (Au), nickel (Ni), neodymium (Nd), iridium (Ir), chrome (Cr), lithium (Li), calcium (Ca), molybdenum (Mo), titanium (Ti), tungsten (W), and/or copper (Cu) by taking into account conductivity and may have a single-layered structure or a multi-layered structure. For example, the source electrode 215 and the drain electrode 217 may include a three-layered structure of Ti/Al/Ti.

A planarization layer 140 may be arranged on the thin film transistor 210. For example, as shown in FIG. 2, in the case where the organic light-emitting diode 300 is arranged at a location higher than the thin film transistor 210, the planarization layer 140 may planarize the bending caused by the thin film transistor 210 by covering the thin film transistor 210. The planarization layer 140 may include, for example, an organic insulating material such as benzocyclobutene (BCB) or hexamethyldisiloxane (HMDSO). Though it is shown in FIG. 2 that the planarization layer 140 includes a single layer, the planarization layer 140 may include a multi-layer. Various modifications may be made. The display device 10 according to the present embodiment may include both a protective layer and the planarization layer 140 or include only the planarization layer 140.

The organic light-emitting diode 300 is arranged on a portion of the planarization layer 140 inside the display area DA of the substrate 100. The organic light-emitting diode 300 includes the pixel electrode 310, an opposite electrode 330, and an intermediate layer 320 between the pixel electrode 310 and the opposite electrode 330. The intermediate layer 320 includes an emission layer.

The planarization layer 140 includes an opening that exposes at least one of the source electrode 215 and the drain electrode 217 of the thin film transistor 210. The pixel electrode 310 is arranged on the planarization layer 140, the pixel electrode 310 being electrically connected to the thin film transistor 210 by contacting one of the source electrode 215 and the drain electrode 217 through the opening.

The pixel electrode 310 may include a (semi) transparent electrode or a reflective electrode. In the case where the pixel electrode 310 includes a (semi) transparent electrode, the pixel electrode 310 may include, for example, indium tin oxide (ITO), indium zinc oxide (IZO), zinc oxide (ZnO), indium oxide (In₂O₃), indium gallium oxide (IGO), or aluminum zinc oxide (AZO). In the case where the pixel electrode 310 includes a reflective layer and a layer, the reflective layer including at least one of Ag, Mg, Al, Pt, Pd, Au, Ni, Nd, Ir, Cr, and a compound thereof, and the layer including ITO, IZO, ZnO, In₂O₃, IGO, or AZO. The pixel electrode 310 may include various materials and a structure of the pixel electrode 310 may include a single layer or a multi-layer.

A pixel-defining layer 150 may be arranged on the planarization layer 140. The pixel-defining layer 150 defines a pixel by including an opening corresponding to sub-pixels, that is, an opening that exposes at least the central portion of the pixel electrode 310. In addition, in the case shown in FIG. 2, the pixel-defining layer 150 may prevent occurrence of an arc at the edges of the pixel electrode 310 by increasing a distance between the edges of the pixel electrode 310 and the opposite electrode 330 over the pixel electrode 310. The pixel-defining layer 150 may include, for example, an organic insulating material such as polyimide or HMDSO.

The intermediate layer 320 of the organic light-emitting diode 300 includes the emission layer. The emission layer may include a polymer organic material or a low molecular weight organic material emitting light having a predetermined color. In addition, the intermediate layer 320 may include at least one functional layer among a hole transport layer (HTL), a hole injection layer (HIL), an electron transport layer (ETL), and an electron injection layer (EIL). The functional layer may include an organic material. Some of the layers constituting the intermediate layer 320, for example, the functional layers, may be formed as one body over the organic light-emitting diodes 300.

The opposite electrode 330 may cover the display area DA. The opposite electrode 330 may be formed as one body over the organic light-emitting diodes 300 to correspond to the pixel electrodes 310. The opposite electrode 330 may include a (semi) transparent electrode or a reflective electrode. In the case where the opposite electrode 330 includes a (semi) transparent electrode, the opposite electrode 330 may include a layer including a metal having a low work function, that is, Li, Ca, lithium fluoride (LiF)/Ca, LiF/AI, Al, Ag, Mg, and a compound thereof, and a (semi) transparent conductive layer including ITO, IZO, ZnO, or In₂O₃. In the case where the opposite electrode 330 includes a reflective electrode, the opposite electrode 330 may include a layer including Li, Ca, lithium fluoride (LiF)/Ca, LiF/AI, Al, Ag, Mg, and a compound thereof.

For the display device 10 to display an image, a predetermined electric signal is applied to the opposite electrode 330. For this purpose, the second voltage line 420, which is the common voltage line ELVSS, may be electrically connected to the opposite electrode 330 and may transfer a predetermined electric signal to the opposite electrode 330.

The opposite electrode 330 may directly contact the second voltage line 420 or, as shown in FIG. 2, be electrically connected to the second voltage line 420 through a protective conduction layer 421. The protective conduction layer 421 may be located on the planarization layer 140, may extend on the second voltage line 420 and thus may be electrically connected to the second voltage line 420. Therefore, the opposite electrode 330 may contact the protective conduction layer 421 in the non-display area PA. The protective conduction layer 421 may contact the second voltage line 420 in the non-display area PA.

Since the protective conduction layer 421 is located on the planarization layer 140 as shown in FIG. 2, the protective conduction layer 421 may include the same materials as those of elements located on the planarization layer 140 inside the display area DA and be formed simultaneously. Specifically, while the pixel electrode 310 is formed on the planarization layer 140 inside the display area DA, the protective conduction layer 421 may be simultaneously formed on the planarization layer 140 in the non-display area PA by using the same material as that of the pixel electrode 310. Therefore, the protective conduction layer 421 has the same structure as that of the pixel electrode 310. As shown in FIG. 2, the protective conduction layer 421 may cover a portion of the second voltage line 420 that is exposed by not being covered by the planarization layer 140. Through this, the second voltage line 420 exposed outside the planarization layer 140 may be prevented from being damaged during a process of forming a first restriction dam 610 or a second restriction dam 620.

To prevent external oxygen or moisture from penetrating into the display area DA through the planarization layer 140, the planarization layer 140 may have an opening 140b in the non-display area PA as shown in FIG. 2. The opening 140b may surround the display area DA. In addition, while the protective conduction layer 421 is formed, the protective conduction layer 421 may fill the opening 140b. Through this, impurities penetrating to a portion of the planarization layer 140 in the non-display area PA may be effectively prevented from penetrating into a portion of the planarization layer 140 inside the display area DA.

A capping layer 160 may be located on the opposite electrode 330. The capping layer 160 improves the efficiency of light emitted from the organic light-emitting diode 300. The capping layer 160 may cover the opposite electrode 330, extend outside the opposite electrode 330, and contact the protective conduction layer 421 located under the opposite electrode 330. Because the opposite electrode 330 covers the display area DA and extends outside the display area DA, the capping layer 160 also covers the display area DA and extends to the non-display area PA beyond the display area DA. The capping layer 160 includes an organic material.

As described above, the capping layer 160 improves the efficiency of light emitted from the organic light-emitting diode 300. For example, the capping layer 160 may raise a light-extracting efficiency to the outside. It is suitable that the efficiency improvement of the capping layer 160 is uniformly made over the display area DA. It is suitable that the capping layer 160 has a top surface corresponding to the bending of a top surface of a layer under the capping layer 160. That is, as shown in FIG. 2, a portion of the capping layer 160 that is located on the opposite electrode 330 may have a top surface having a shape corresponding to the bending of a top surface of the opposite electrode 330.

An encapsulation layer 500 is located over the capping layer 160. The encapsulation layer 500 protects the organic light-emitting diode 300 from external oxygen or moisture. For this purpose, the encapsulation layer 500 has a shape extending to the non-display area PA outside the display area DA as well as the display area DA in which the organic light-emitting diode 300 is located. The encapsulation layer 500 may have a multi-layered structure. Specifically, as shown in FIG. 2, the encapsulation layer 500 may include a first inorganic encapsulation layer 510, an organic encapsulation layer 520, and a second inorganic encapsulation layer 530.

The first inorganic encapsulation layer 510 may cover the capping layer 160 and include silicon oxide, silicon nitride, and/or silicon oxynitride.

Since the first inorganic encapsulation layer 510 is formed along a structure under the first inorganic encapsulation layer 510, a top surface of the first inorganic encapsulation layer 510 may not be flat as shown in FIG. 2. Because the organic encapsulation layer 520 covers the first inorganic encapsulation layer 510 and has a sufficient thickness, a top surface of the organic encapsulation layer 520 may be substantially flat over the display area DA. The organic encapsulation layer 520 may include polyethylene terephthalate, polyethylene naphthalate, polycarbonate, polyimide, polyethylene sulfonate, polyoxymethylene, polyarylate, hexamethyldisiloxane, an acrylic resin, e.g. polymethylmethacrylate, poly acrylic acid, or an arbitrary combination thereof.

The second inorganic encapsulation layer 530 may cover the organic encapsulation layer 520 and include silicon oxide, silicon nitride, and/or silicon oxynitride. The second inorganic encapsulation layer 530 may allow the organic encapsulation layer 520 not to be exposed to the outside by extending outside the organic encapsulation layer 520 and contacting the first inorganic encapsulation layer 510.

Since the encapsulation layer 500 includes the first inorganic encapsulation layer 510, the organic encapsulation layer 520, and the second inorganic encapsulation layer 530, even though a crack occurs inside the encapsulation layer 500, the crack may not be connected between the first inorganic encapsulation layer 510 and the organic encapsulation layer 520, or between the organic encapsulation layer 520 and the second inorganic encapsulation layer 530 through this multi-layered structure. Through this configuration, forming of a path through which external oxygen or moisture penetrate into the display area DA may be prevented or minimized.

During a process of forming the encapsulation layer 500, structures under the encapsulation layer 500 may be damaged. For example, the first inorganic encapsulation layer 510 may be formed by using chemical vapor deposition. While the first inorganic encapsulation layer 510 is formed by using chemical vapor deposition, a layer right under the first inorganic encapsulation layer 510 may be damaged. Therefore, when the first inorganic encapsulation layer 510 is directly formed on the capping layer 160, the capping layer 160, which improves the efficiency of light emitted from the organic light-emitting diode 300, may be damaged and thus a light efficiency of the display device 10 may be deteriorated. Therefore, to prevent the capping layer 160 from being damaged during a process of forming the encapsulation layer 500, a protective layer 170 may be arranged between the capping layer 160 and the encapsulation layer 500. The protective layer 170 may include LiF.

As described above, the capping layer 160 extends to the non-display area PA as well as the display area DA. Therefore, the protective layer 170 extends outside the capping layer 160 such that the capping layer 160 does not directly contact the encapsulation layer 500. In this case, the protective layer 170 covers an end 160a of the capping layer 160 and accordingly, an end 170a of the protective layer 170 is located over the planarization layer 140. Specifically, as shown in FIG. 2, the end 170a of the protective layer 170 directly contacts the protective conduction layer 421 on the planarization layer 140.

Therefore, because the first inorganic encapsulation layer 510, which is a lowermost layer of the encapsulation layer 500, does not contact the capping layer 160 including an organic material and contacts the protective layer 170 including an inorganic material, adhesive force between the encapsulation layer 500 and a layer under the encapsulation layer 500 may be maintained high. Therefore, the encapsulation layer 500 may be effectively prevented from being exfoliated from the layer under the encapsulation layer 500 during a process of manufacturing the display device 10 or a use process after the manufacturing.

When forming the encapsulation layer 500, specifically, when forming the organic encapsulation layer 520, it is required to limit a material for forming the organic encapsulation layer 520 such that the material for forming the organic encapsulation layer 520 is located inside a region set in advance. For this purpose, as shown in FIG. 2, the first restriction dam 610 may be located in the non-display area PA. Specifically, the first inorganic insulating layer 120, the second inorganic insulating layer 130, and the planarization layer 140 may be in the non-display area PA as well as the display area DA as shown in FIG. 2. The first restriction dam 610 is located in the non-display area PA to be apart from the planarization layer 140.

The first restriction dam 610 may have a multi-layered structure. That is, the first restriction dam 610 may include a bottom layer 611 and a top layer 613 sequentially in a direction away from the substrate 100. The bottom layer 611 may be simultaneously formed while a portion of the planarization layer 140 in the display area DA is formed and may include the same material as the planarization layer 140. The top layer 613 may be simultaneously formed while a portion of the pixel-defining layer 150 in the display area DA is formed and may include the same material as the pixel-defining layer 150.

As shown in FIG. 2, in addition to the first restriction dam 610, the second restriction dam 620 may be between the first restriction dam 610 and an end 140a of the planarization layer 140. The second restriction dam 620 may be on a portion of the protective conduction layer 421 on the second voltage line 420. The second restriction dam 620 is located in the non-display area PA and is apart from the planarization layer 140. Like the first restriction dam 610, the second restriction dam 620 may have a multi-layered structure and include less layers than the first restriction dam 610 such that a height of the second restriction dam 620 from the substrate 100 is less than a height of the first restriction dam 610 from the substrate 100. It is shown in FIG. 2 that the second restriction dam 620 is simultaneously formed with the top layer 613 of the first dam 610 and includes the same material as that of the top layer 613.

Therefore, because the location of the organic encapsulation layer 520 is limited by the second restriction dam 620, a material for forming the organic encapsulation layer 520 may be prevented from overflowing to the outside of the second restriction dam 620 during a process of forming the organic encapsulation layer 520. Even if the material for forming the organic encapsulation layer 520 partially overflows to the outside of the second restriction dam 620, the location of the organic encapsulation layer 520 is limited by the first restriction dam 610. Accordingly, the material for forming the organic encapsulation layer 520 may no longer move in a direction to an edge 100a of the substrate 100. In contrast, the first inorganic encapsulation layer 510 and the second inorganic encapsulation layer 530 formed by using chemical vapor deposition cover the second restriction dam 620 and the first restriction dam 610 and are formed to the outside of the first restriction dam 610 as shown in FIG. 2.

A bank 630 is further located outside the first restriction dam 610. The bank 630 surrounds the first restriction dam 610. The bank 630 supports masks used when forming the intermediate layer 320 or the opposite electrode 330 of the organic light-emitting diode 300 during a process of manufacturing the display device 10. During this process, the bank 630 prevents previously formed elements from contacting the masks and being damaged. For example, the bank 630 may have a structure in which a first layer 631, a second layer 633, and a third layer 635 are stacked. The first layer 631 may be simultaneously formed while the planarization layer 140 is formed and may include the same material as the planarization layer 140. The second layer 633 may be simultaneously formed while the pixel-defining layer 150 is formed and may include the same material as the pixel-defining layer 150. The third layer 635 may be additionally formed on the second layer 633 and may include the same material as the second layer 633. For example, the third layer 635 may be simultaneously formed with the second layer 633 by using a half-tone mask while the pixel-defining layer 150 is formed. The first inorganic encapsulation layer 510 and the second inorganic encapsulation layer 530 may be formed to the outside of the bank 630.

As shown in FIG. 2, a crack prevention portion 640 is located in the non-display area PA. The crack prevention portion 640 may extend along at least a portion of the edge 100a of the substrate 100. For example, the crack prevention portion 640 may have a shape that circumnavigates the display area DA once. The crack prevention portion 640 may have a discontinuous shape in some sections. The crack prevention portion 640 may prevent a crack from being transferred to the display area DA, the crack occurring in the first inorganic insulating layer 120 and the second inorganic insulating layer 130 each including an inorganic material while a parent substrate is cut during a process of manufacturing the display device 10, or due to an impact, while the display device 10 is in use.

The crack prevention portion 640 may have various shapes. As shown in FIG. 2, the crack prevention portion 640 may be simultaneously formed with some elements formed in the display area DA, may include the same material as the some elements, and have a multi-layered structure. It is shown in FIG. 2 that the crack prevention portion 640 has a multi-layered structure including a bottom layer 640' and a top layer 640", the top layer 640" being located on the bottom layer 640'. Specifically, it is shown in FIG. 2 that the crack prevention portion 640 includes the bottom layer 640' and the top layer 640". The bottom layer 640' includes the same material as the first inorganic insulating layer 120, and the top layer 640" includes the same material as the second inorganic insulating layer 130 on the first inorganic insulating layer 120. In the case where the buffer layer is formed on the substrate 100, the crack prevention portion 640 may include a layer including the same material as the buffer layer. In addition, as shown in FIG. 2, the crack prevention portion 640 may include layers apart from each other, not one layer.

The crack prevention portion 640 may be formed by removing a portion of the first inorganic insulating layer 120 and the second inorganic insulating layer 130. That is, as shown in FIG. 2, a groove in which the first inorganic insulating layer 120 and the second inorganic insulating layer 130 are removed is formed on at least one side of the crack prevention portion 640. The crack prevention portion 640 may include a remnant of the first inorganic insulating layer 120 and the second inorganic insulating layer 130 that neighbors the groove.

The crack prevention portion 640 may be covered by a cover layer 650, as shown in FIG. 2. The cover layer 650 may be simultaneously formed while the planarization layer 140, for example, is formed in the display area DA and may include the same material as the planarization layer 140. That is, the cover layer 650 may include a layer including an organic material that covers the crack prevention portion 640 including the inorganic material. The cover layer 650 may cover the ends of the first inorganic insulating layer 120 and/or the second inorganic insulating layer 130 in the direction to the edge 100a of the substrate 100 and cover the crack prevention portion 640.

As shown in FIG. 2, the second voltage line 420 may extend in the direction to the edge 100a of the substrate 100, and an end 420a of the second voltage line 420 may be located outside the bank 630 and covered by the cover layer 650. Therefore, because the width of the second voltage line 420 may increase on at least two opposite sides of the display area DA, even though the non-display area PA is reduced, the width of the second voltage line 420 may not be reduced together. Accordingly, the display quality of the display device 10 may be prevented from being deteriorated by an increase of the resistance of the second voltage line 420.

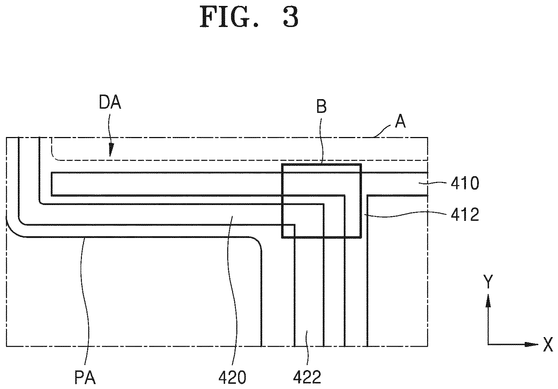

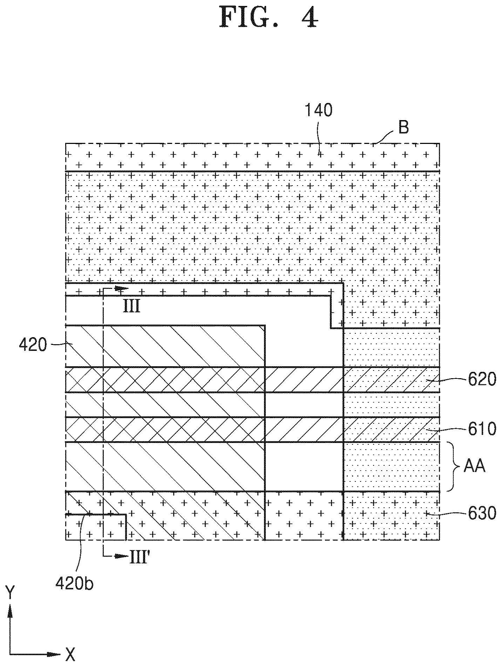

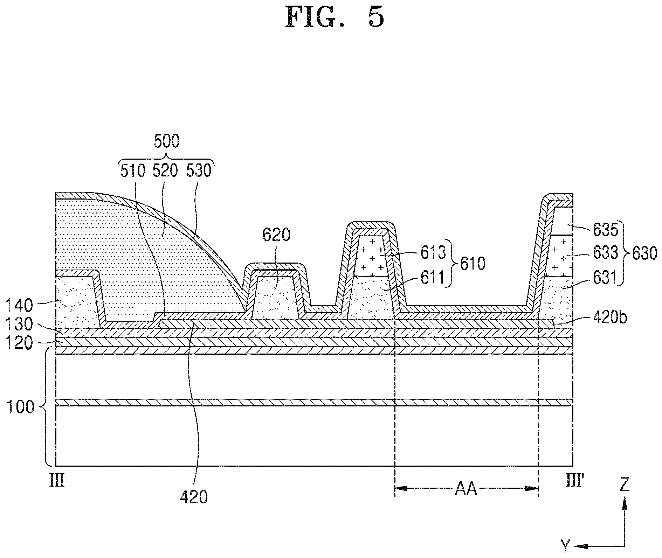

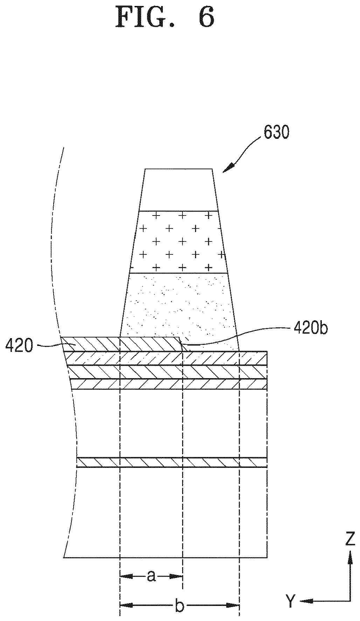

FIG. 3 is a plan view of a region A of FIG. 1. FIG. 4 is a plan view of a region B of FIG. 3. FIG. 5 is a cross-sectional view of an example of a cross-section of the region B taken along line III-III' of FIG. 4. FIG. 6 is a cross-sectional view of a bank portion of FIG. 5.

Referring to FIGS. 3 to 5, the first voltage line 410 and the second voltage line 420 may be located in the non-display area PA. The first voltage line 410 and the second voltage line 420 supply a voltage to the organic light-emitting diode 300, e.g., see FIG. 2. For example, the first voltage line 410 may include the driving voltage line ELVDD. The second voltage line 420 may include the common voltage line ELVSS. As described above, the second voltage line 420 may be directly connected to the opposite electrode 330, e.g., see FIG. 2, or be connected to the opposite electrode 330 through another wiring. The first voltage line 410 and the second voltage line 420 may be simultaneously formed while the source electrode 215, e.g., see FIG. 2, and the drain electrode 217, e.g., see FIG. 2, are formed and may include the same material as those of the source electrode 215 and the drain electrode 217.

The first voltage line 410 may be arranged between one side of the display area DA and the pad area PADA, e.g., see FIG. 1. The first voltage line 410 may be arranged to correspond to one side of the display area DA and connected to the first connector 412. For example, in the case where the display area DA has a rectangular shape, the first voltage line 410 may be arranged to one of sides of the display area DA. The first voltage line 410 may be parallel to one of the sides and may have a length equal to or greater than one of the sides. One of the sides that corresponds to the first voltage line 410 may include a side neighboring the pad area PADA, e.g., see FIG. 1.

The second voltage line 420 surrounds at least a portion of the display area DA. For example, the second voltage line 420 surrounds two opposite ends of the first voltage line 410 and the display area DA and be connected to the second connector 422. The second connector 422 may be connected to a pad portion.

Since the first restriction dam 610, the second restriction dam 620, and the bank 630 surround the display area DA, they are located also between the display area DA and the pad area PADA, e.g., see FIG. 1, as shown in FIGS. 4 and 5. Through this configuration, when forming the encapsulation layer 500, specifically, when forming the organic encapsulation layer 520, the material for forming the organic encapsulation layer 520 may be located within a region set in advance, and the first inorganic encapsulation layer 510 and the second inorganic encapsulation layer 530 are formed to cover the bank 630.

An outer end 420b of the second voltage line 420 overlaps the bank 630 between the display area DA and the pad area PADA, e.g., see FIG. 1. That is, the outer end 420b of the second voltage line 420 is covered by the bank 630. Through this configuration, the area of the second voltage line 420 may be expanded compared to the case where the outer end 420b is covered by the first dam 610 in the related art. Therefore, even though an interval between the display area DA and the pad area PADA, e.g., see FIG. 1, is reduced to reduce a dead space, because the width of the second voltage line 420 in the relevant region is not influenced or may rather increase, the resistance of the second voltage line 420 may be prevented from increasing.

Between the display area DA and the pad area PADA, e.g., see FIG. 1, a space between the first restriction dam 620 and the bank 630 is a region in which only the inorganic layers, that is, the first inorganic insulating layer 120, the second inorganic insulating layer 130, the first inorganic encapsulation layer 510, and the second inorganic encapsulation layer 530, are located. In this region, because the first inorganic encapsulation layer 510 directly contacts the second inorganic encapsulation layer 530 and another layer in the lower portion, for example, the second inorganic insulating layer 130, adhesive force of the encapsulation layer 500 may be improved. Therefore, between the display area DA and the pad area PADA, e.g., see FIG. 1, a region between the first restriction dam 610 and the bank 630 may be defined as an adhesive region AA.

The second connector 422 connected to the second voltage line 420 is exposed in the adhesive region AA, the first inorganic encapsulation layer 510 covers a top surface and a lateral surface of the second connector 422, and the second connector 422 may be formed in plural. In this case, step differences are formed by the second connectors 422 in a direction perpendicular to a lengthwise direction of the second connectors 422. Accordingly, damage to the first inorganic encapsulation layer 510 covering the second connectors 422 may be caused by the bending of the second connectors 422. In contrast, in the case where the second voltage line 420 extends to the bank 630, because occurrence of step differences caused by the second connectors 422 may be minimized in the adhesive region AA as shown in FIG. 5, damage to the first inorganic encapsulation layer 510 may be prevented from occurring.

As shown in FIG. 6, the outer end 420b of the second voltage line 420 facing the pad area PADA is covered by the bank 630. In this case, a difference between a width b of the bottom end of the bank 630 and a width a of the second voltage line 420 may be 1.5 µm or more. This means that a distance between the outer end 420b and an outer surface of the bank 630 is 1.5 µm or more. Through this configuration, during a process of forming the first restriction dam 610 or the second restriction dam 620, damage to the second voltage line 420 exposed to the outside of the planarization layer 140 may be prevented. To prevent the bank 630 from being pulled out during a process of manufacturing the display device 10, e.g., see FIG. 10, the bottom width b of the bank 630, which is in a direction perpendicular to the lengthwise direction of the bank 630, may be 40 µm or more.

More specifically, in the case where the second voltage line 420 has a triple-layered structure of Ti/Al/Ti, when the outer end 420b is exposed to a developer for etching the planarization layer 140 during a process of patterning the planarization layer 140, an Al layer having a relatively high etching rate may be excessively etched compared to a Ti layer. Accordingly, the Al layer is further indented to the inner side of the outer end 420b and thus an undercut structure may be formed. Under this state, when the first inorganic encapsulation layer 510 and the second inorganic encapsulation layer 530 are formed, damage such as a crack may be caused to the first inorganic encapsulation layer 510 and the second inorganic encapsulation layer 530 due to reduction of step coverage in the lateral surface of the outer end 420b. In contrast, according to the invention, the bank 630 covers the outer end 420b of the second voltage line 420. In this case, a difference between the bottom width b of the bank 630 and the width a of the second voltage line 420 covered by the bank 630 is maintained to be 1.5 µm or more. Therefore, the outer end 420b may be prevented from being exposed to a developer for etching the planarization layer 140.

In addition, the width a of the second voltage line 420 covered by the bank 630 may be 1.5 µm or more. As described above, the bank 630 should cover the outer end 420b of the second voltage line 420. However, in the case where the width a of the second voltage line 420 covered by the bank 630 is less than 1.5 µm, when an error occurs during a process of forming the bank 630, the outer end 420b may not be covered by the bank 630. Therefore, the width a of the second voltage line 420 covered by the bank 630 may be formed to have 1.5 µm or more by taking into account a process margin.

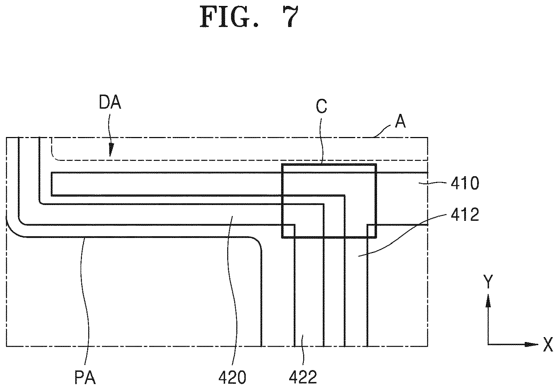

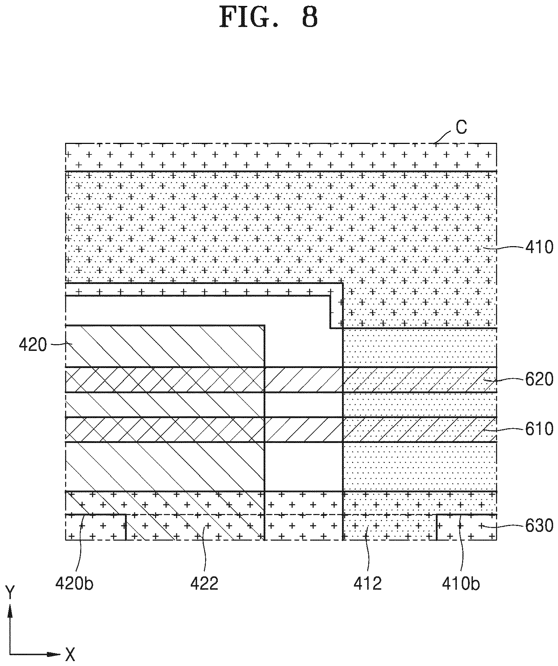

FIG. 7 is a plan view of the region A of FIG. 1 in accordance with an embodiment. FIG. 8 is a plan view of a region C of FIG. 7. FIGS. 7 and 8 show the same locations as FIGS. 3 and 4. Therefore, similar descriptions already given above are omitted.

Referring to FIGS. 7 and 8, the first voltage line 410 is arranged between one side of the display area DA and the pad area PADA, e.g., see FIG. 1, and the second voltage line 420 may surround the rest of regions of the display area DA.

In this case, the first restriction dam 610 and the second restriction dam 620 are located on the second voltage line 420 between the display area DA and the pad area PADA, e.g., see FIG. 1, and the outer end 420b of the second voltage line 420 is covered by the bank 630. That is, compared to the case where the outer end 420b of the second voltage line 420 is covered by the first restriction dam 610, the width of the second voltage line 420 between the display area DA and the pad area PADA, e.g., see FIG. 1, may be increased.

In addition, the area of the first voltage line 410 expands such that an outer end 410b of the first voltage line 410 facing the pad area PADA, e.g., see FIG. 1, between the display area DA and the pad area PADA, e.g., see FIG. 1, is covered by the bank 630. As described with reference to FIG. 1, a pair of second connectors 422 may be respectively connected to the two opposite ends of the second voltage line 420, and the first voltage line 410 may be connected to a pair of first connectors 412 located between a pair of second connectors 422. In this case, a region in which the outer end 410b of the first voltage line 410 is covered by the bank 630 between the display area DA and the pad area PADA, e.g., see FIG. 1, is between the two opposite ends of the second voltage line 420 or between a pair of second connectors 422. For example, in the case where a pair of second connectors 422 neighbor a pair of first connectors 412, the area of the outer end 410b of the first voltage line 410 between a pair of first connectors 412 may expand such that the outer end 410b is covered by the bank 630. Through this configuration, the resistance of the first voltage line 410 may be reduced and simultaneously a short circuit between the first voltage line 410 and the second voltage line 420 may be prevented. For example, the outer end 420b of the second voltage line 420 and the outer end 410b of the first voltage line 410 may be located on the same straight line. Therefore, because the areas of the first voltage line 410 and the second voltage line 420 increase, even though a dead space of the display device 10, e.g., see FIG. 1, is reduced, an increase of power consumption of the display device 10, e.g., see FIG. 1, and deterioration of the display quality may be prevented.

## Claims

1. A display device comprising:
a substrate (100) including a display area (DA) a non-display area (PA) and a pad area (PADA) the non-display area being outside the display area, and the pad area being on one side of the non-display area;
a first restriction dam (610) in the non-display area and surrounding the display area;
a second restriction dam (620) in the non-display area and surrounding the display area between the display area and the first restriction dam;
a bank (630) surrounding the display area outside the first restriction dam; and
a voltage line (410, 420) configured to supply a voltage to a display element inside the display area,
wherein the first restriction dam and the second restriction dam are over the voltage line between the display area and the pad area, and the voltage line extends to the bank beyond the first restriction dam, and, wherein the voltage line includes a first voltage line (410) and a second voltage line (420), the first voltage line being between the display area and the pad area, and the second voltage line surrounding two opposites ends of the first voltage line and at least a portion of the display area,
wherein
an outer end (420b) of the second voltage line facing the pad area is covered by the bank between the display area and the pad area, and **characterized in that**
an outer end (410b) of the first voltage line that faces the pad area is covered by the bank between two opposite ends of the second voltage line.

2. The display device of claim 1, wherein a difference between a width of the bank and a width of the second voltage line is 1.5 µm or more between the display area and the pad area, the width of the bank being taken in a direction perpendicular to a lengthwise direction of the bank, and the width of the second voltage line being covered by the bank.

3. The display device of claim 2, wherein a distance between the outer end of the second voltage line and an outer surface of the bank is 1.5 µm or more.

4. The display device of claim 1, wherein the outer end of the first voltage line and the outer end of the second voltage line are over the same straight line.

5. The display device of any one of claims 2 to 4, wherein the second voltage line extends to the outside of the bank from a region surrounding the display area.

6. The display device of claim 5, further comprising:
a crack prevention portion (640) extending along an edge of the substrate, and a cover layer (650) covering the crack prevention layer, the crack prevention layer being formed by removing a portion of inorganic layers stacked on the substrate,
wherein an end of the second voltage line extending to the outside of the bank is covered by the cover layer.

7. The display device of any one of claims 2 to 6, wherein a height of the second restriction dam is less than a height of the first restriction dam, and
the first restriction dam and the second restriction dam are over the second voltage line between the display area and the pad area.

8. The display device of any one of claims 1 to 7, further comprising an encapsulation layer (500) over the display element and including a first inorganic encapsulation layer (510), an organic encapsulation layer (520), and a second inorganic encapsulation layer (530) that are sequentially stacked,
wherein the first inorganic encapsulation layer directly contacts the voltage line between the display area and the pad area.

## Patentansprüche

1. Anzeigevorrichtung, umfassend:
ein Substrat (100), das einen Anzeigebereich (DA), einen Nicht-Anzeigebereich (PA) und einen Pad-Bereich (PADA) beinhaltet, wobei der Nicht-Anzeigebereich außerhalb des Anzeigebereichs ist und der Pad-Bereich auf einer Seite des Nicht-Anzeigebereichs ist;
einen ersten Begrenzungsdamm (610) in dem Nicht-Anzeigebereich, und der den Anzeigebereich umgibt;
einen zweiten Begrenzungsdamm (620) in dem Nicht-Anzeigebereich, und der den Anzeigebereich zwischen dem Anzeigebereich und dem ersten Begrenzungsdamm umgibt;
eine Bank (630), die den Anzeigebereich außerhalb des ersten Begrenzungsdamms umgibt; und
eine Spannungsleitung (410, 420), die konfiguriert ist, um eine Spannung an ein Anzeigeelement innerhalb des Anzeigebereichs zuzuführen,
wobei der erste Begrenzungsdamm und der zweite Begrenzungsdamm über der Spannungsleitung zwischen dem Anzeigebereich und dem Pad-Bereich sind und sich die Spannungsleitung über den ersten Begrenzungsdamm hinaus zu der Bank erstreckt, und wobei die Spannungsleitung eine erste Spannungsleitung (410) und eine zweite Spannungsleitung (420) beinhaltet, wobei die erste Spannungsleitung zwischen dem Anzeigebereich und dem Pad-Bereich ist und die zweite Spannungsleitung zwei entgegengesetzte Enden der ersten Spannungsleitung und mindestens einen Abschnitt des Anzeigebereichs umgibt,
wobei ein äußeres Ende (420b) der zweiten Spannungsleitung, das dem Pad-Bereich zugewandt ist, durch die Bank zwischen dem Anzeigebereich und dem Pad-Bereich abgedeckt ist, und
**dadurch gekennzeichnet, dass**
ein äußeres Ende (410b) der ersten Spannungsleitung, das dem Pad-Bereich zugewandt ist, von der Bank zwischen zwei gegenüberliegenden Enden der zweiten Spannungsleitung abgedeckt wird.

2. Anzeigevorrichtung nach Anspruch 1, wobei eine Differenz zwischen einer Breite der Bank und einer Breite der zweiten Spannungsleitung 1,5 µm oder mehr zwischen dem Anzeigebereich und dem Pad-Bereich ist, wobei die Breite der Bank in einer Richtung senkrecht zu einer Längsrichtung der Bank gemessen wird und die Breite der zweiten Spannungsleitung durch die Bank abgedeckt wird.

3. Anzeigevorrichtung nach Anspruch 2, wobei ein Abstand zwischen dem äußeren Ende der zweiten Spannungsleitung und einer Außenfläche der Bank 1,5 µm oder mehr ist.

4. Anzeigevorrichtung nach Anspruch 1, wobei das äußere Ende der ersten Spannungsleitung und das äußere Ende der zweiten Spannungsleitung auf derselben Geraden sind.

5. Anzeigevorrichtung nach einem der Ansprüche 2 bis 4, wobei sich die zweite Spannungsleitung von einer den Anzeigebereich umgebenden Region zu der Außenseite der Bank erstreckt.

6. Anzeigevorrichtung nach Anspruch 5, ferner umfassend:
einen Rissverhinderungsabschnitt (640), der sich entlang eines Rands des Substrats erstreckt, und
eine Deckschicht (650), die die Rissverhinderungsschicht abdeckt, wobei die Rissverhinderungsschicht durch Entfernen eines Abschnitts von anorganischen Schichten gebildet ist, die auf dem Substrat gestapelt sind,
wobei ein Ende der zweiten Spannungsleitung, das sich zu der Außenseite der Bank erstreckt, von der Deckschicht abgedeckt ist.

7. Anzeigevorrichtung nach einem der Ansprüche 2 bis 6, wobei eine Höhe des zweiten Begrenzungsdamms geringer ist als eine Höhe des ersten Begrenzungsdamms, und
der erste Begrenzungsdamm und der zweite Begrenzungsdamm über der zweiten Spannungsleitung zwischen dem Anzeigebereich und dem Pad-Bereich sind.

8. Anzeigevorrichtung nach einem der Ansprüche 1 bis 7, ferner umfassend eine Verkapselungsschicht (500) über dem Anzeigeelement, und die eine erste anorganische Verkapselungsschicht (510), eine organische Verkapselungsschicht (520) und eine zweite anorganische Verkapselungsschicht (530), die nacheinander gestapelt sind, beinhaltet,
wobei die erste anorganische Verkapselungsschicht die Spannungsleitung zwischen dem Anzeigebereich und dem Pad-Bereich direkt berührt.

## Revendications

1. Dispositif d'affichage comprenant :
un substrat (100) comprenant une zone d'affichage (DA), une zone de non-affichage (PA) et une zone de tampon (PADA)
la zone de non-affichage étant à l'extérieur de la zone d'affichage, et la zone de tampon étant sur un côté de la zone de non-affichage ;
un premier barrage de restriction (610) dans la zone de non-affichage et entourant la zone d'affichage ;
un second barrage de restriction (620) dans la zone de non-affichage et entourant la zone d'affichage entre la zone d'affichage et le premier barrage de restriction ;
un banc (630) entourant la zone d'affichage à l'extérieur du premier barrage de restriction ; et
une ligne de tension (410, 420) configurée pour délivrer une tension à un élément d'affichage à l'intérieur de la zone d'affichage,
dans lequel le premier barrage de restriction et le second barrage de restriction se trouvent sur la ligne de tension entre la zone d'affichage et la zone de tampon, et la ligne de tension s'étend jusqu'au banc au-delà du premier barrage de restriction, et dans lequel la ligne de tension comprend une première ligne de tension (410) et une seconde ligne de tension (420), la première ligne de tension étant entre la zone d'affichage et la zone de tampon, et la seconde ligne de tension entourant deux extrémités opposées de la première ligne de tension et au moins une partie de la zone d'affichage,
dans lequel une extrémité externe (420b) de la seconde ligne de tension faisant face à la zone de tampon est recouverte par le banc entre la zone d'affichage et la zone de tampon, et
**caractérisé en ce que**
une extrémité externe (410b) de la première ligne de tension qui fait face à la zone de tampon est recouverte par le banc entre deux extrémités opposées de la seconde ligne de tension.

2. Dispositif d'affichage selon la revendication 1, dans lequel une différence entre une largeur du banc et une largeur de la seconde ligne de tension est de 1,5 µm ou plus entre la zone d'affichage et la zone de tampon, la largeur du banc étant prise dans une direction perpendiculaire à une direction longitudinale du banc, et la largeur de la seconde ligne de tension étant couverte par le banc.

3. Dispositif d'affichage selon la revendication 2, dans lequel une distance entre l'extrémité externe de la seconde ligne de tension et une surface externe du banc est de 1,5 µm ou plus.

4. Dispositif d'affichage selon la revendication 1, dans lequel l'extrémité externe de la première ligne de tension et l'extrémité externe de la seconde ligne de tension se trouvent sur la même ligne droite.

5. Dispositif d'affichage selon l'une quelconque des revendications 2 à 4, dans lequel la seconde ligne de tension s'étend vers l'extérieur du banc à partir d'une région entourant la zone d'affichage.

6. Dispositif d'affichage de la revendication 5, comprenant en outre :
une partie de prévention des fissures (640) s'étendant le long d'un bord du substrat, et une couche de couverture (650) recouvrant la couche de prévention des fissures, la couche de prévention des fissures étant formée en retirant une partie de couches inorganiques empilées sur le substrat,
dans lequel une extrémité de la seconde ligne de tension s'étendant vers l'extérieur du banc est couverte par la couche de couverture.

7. Dispositif d'affichage selon l'une quelconque des revendications 2 à 6, dans lequel une hauteur du second barrage de restriction est inférieure à une hauteur du premier barrage de restriction, et
le premier barrage de restriction et le second barrage de restriction se trouvent sur la seconde ligne de tension entre la zone d'affichage et la zone de tampon.

8. Dispositif d'affichage selon l'une quelconque des revendications 1 à 7, comprenant en outre une couche d'encapsulation (500) sur l'élément d'affichage et comprenant une première couche d'encapsulation inorganique (510), une couche d'encapsulation organique (520) et une seconde couche d'encapsulation inorganique (530) qui sont empilées séquentiellement,
dans lequel la première couche d'encapsulation inorganique est directement en contact avec la ligne de tension entre la zone d'affichage et la zone de tampon.
